# EUROPEAN PATENT APPLICATION

(11) **EP 4 682 101 A1**
(43) Date of publication of application: **21.01.2026**
(21) Application number: 25187070.5
(22) Date of filing: 02.07.2025
(51) Int. Cl.: B81C 99/00, G01P 21/00

(54) **CALIBRATION DEVICE**

(30) Priority: 15.07.2024 US 202418773347
(71) Applicant: NXP USA, Inc., Austin, TX 78735 (US)
(72) Inventor: Dawson, Chad, 5656 AG Eindhoven (NL); McNeil, Andrew C., 5656 AG Eindhoven (NL); Stanley, James Douglas, 5656 AG Eindhoven (NL)
(74) Representative: Schmütz, Christian Klaus Johannes

(57) **Abstract**

One example discloses a calibration device, including: a substrate; a torsional element; wherein a first end of the torsional element is coupled to the substrate; wherein a second end of the torsional element is moveable and defines a capacitance with the substrate; a bias electrode coupled to the substrate; wherein the torsional element and the bias electrode are positioned such that a bias voltage applied between the substrate and the bias electrode creates an electrostatic force between the bias electrode and the torsional element; wherein the electrostatic force causes movement between the torsional element and the substrate; and wherein the movement varies the capacitance.

## Description

The present specification relates to systems, methods, apparatuses, devices, articles of manufacture and instructions for calibration of semiconductor structures and sensors, such as MEMS (microelectromechanical system) devices.

### SUMMARY

According to an example embodiment, a calibration device, comprising: a substrate; a torsional element; wherein a first end of the torsional element is coupled to the substrate; wherein a second end of the torsional element is moveable and defines a capacitance with the substrate; a bias electrode coupled to the substrate; wherein the torsional element and the bias electrode are positioned such that a bias voltage applied between the substrate and the bias electrode creates an electrostatic force between the bias electrode and the torsional element; wherein the electrostatic force causes movement between the torsional element and the substrate; and wherein the movement varies the capacitance.

In another example embodiment, the torsional element is a spring.

In another example embodiment, the second end of the torsional element is coupled to a moveable proof mass.

In another example embodiment, the bias electrode is a first bias electrode positioned apart from and to a first side of the torsional element; further comprising a second bias electrode coupled to the substrate and positioned apart from and to a second side of the torsional element; wherein the first side and the second side are on opposite sides of the torsional element.

In another example embodiment, the bias voltage applied between the substrate and the first bias electrode creates a first electrostatic force that moves the torsional element in a first direction and sets the capacitance to a first capacitance; and the bias voltage applied between the substrate and the second bias electrode creates a second electrostatic force that moves the torsional element in a second direction and sets the capacitance to a second capacitance.

In another example embodiment, the substrate and the torsional element are formed in parallel x-y-planes; and the bias voltage causes the torsional element movement in a z-axis that is perpendicular to the x-y-planes.

In another example embodiment, the torsional element has a trapezoidal cross-section along the z-axis.

In another example embodiment, the electrostatic force simulates a lateral acceleration of the torsional element.

In another example embodiment, further comprising a first bottom electrode and a second bottom electrode, both coupled to the substrate; wherein the electrostatic force moves the torsional element away from the first bottom electrode and closer to the second bottom electrode.

In another example embodiment, the capacitance variation defines a cross-axis sensitivity of the torsional element.

In another example embodiment, further comprising a controller; wherein the controller is configured to calculate the cross-axis sensitivity based on the capacitance variation in response to the bias voltage.

In another example embodiment, the bias electrode is included in a first set of bias electrodes all coupled to the substrate and positioned along both the first side and the second side of the torsional element; further comprising a second set of bias electrodes all coupled to the substrate and positioned along both the first side and the second side of the torsional element.

In another example embodiment, the controller is configured to apply the bias voltage to the first set of bias electrodes and apply a ground voltage to the second set of bias electrodes at a same time.

In another example embodiment, increasing a number of bias electrodes in either or both the first and second sets of bias electrodes increases the capacitance variation in response to the bias voltage.

In another example embodiment, the calibration device is configured to calibrate a fabricated semiconductor structure.

In another example embodiment, the calibration device is configured to calibrate a MEMS (microelectromechanical system) device.

In another example embodiment, the calibration device is configured to calibrate a pressure sensor.

In another example embodiment, the calibration device is configured to calibrate an accelerometer.

In another example embodiment, the calibration device is a metrology structure embedded in a wafer separate from a set of devices to be calibrated.

According to an example embodiment, a method of calculating cross-axis sensitivity using a calibration device: wherein the calibration device includes, a substrate; a torsional element; wherein a first end of the torsional element is coupled to the substrate; wherein a second end of the torsional element is moveable and defines a capacitance with the substrate; a bias electrode coupled to the substrate; wherein the torsional element and the bias electrode are positioned such that a bias voltage applied between the substrate and the bias electrode creates an electrostatic force between the bias electrode and the torsional element; wherein the electrostatic force causes movement between the torsional element and the substrate; and wherein the movement varies the capacitance; and wherein the method of calculating cross-axis sensitivity includes, applying the bias voltage across the bias electrode and the torsional element; measuring the capacitance variation between the torsional element and the substrate; and calculating the cross-axis sensitivity based on the capacitance variation in response to the applied bias voltage.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figures 1A, 1B, 1C represent an example MEMS (microelectromechanical system) device.
Figures 2A, 2B represent an example of a calibration device.
Figures 3A, 3B, 3C represent an example potential non-ideality in the calibration device.
Figures 4A, 4B, 4C represent example set of simulation results for various example embodiments of the calibration device.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the fscope of the appended claims are covered as well.

### DETAILED DESCRIPTION

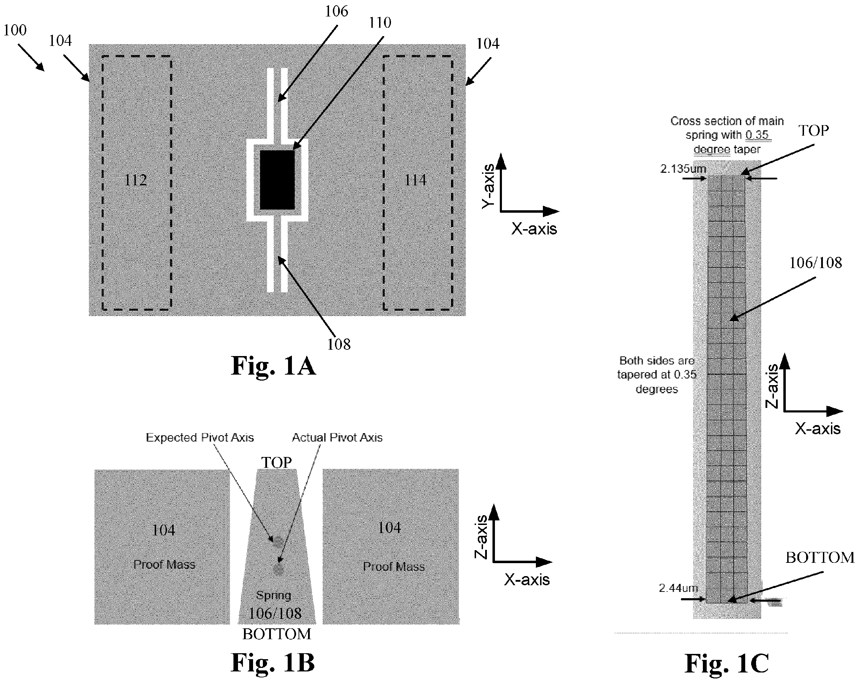

Figures 1A, 1B, 1C represent an example MEMS (microelectromechanical system) device 100. The example MEMS device 100 is fabricated in an x-y-plane over a semiconductor substrate (not shown), and in some examples may be embedded in a semiconductor wafer having other MEMS devices (not shown). The example MEMS device 100 includes a proof mass 104, a first spring 106 having a TOP surface and a BOTTOM surface along a z-axis arising out of the x-y-plane, a second spring 108 also having a TOP surface and a BOTTOM surface along a z-axis arising out of the x-y-plane, and an anchor 110.

The anchor 110 (e.g. pivot point) is physically coupled to one end of both the first spring 106 and the second spring 108. The anchor 110 is also physically coupled to the substrate (not shown). Another end of both the first spring 106 and the second spring 108 is physically coupled to the proof mass 104. The proof mass 104 is sensitive to various forces (e.g. pressure, acceleration, etc.) that cause the proof mass 104 to wobble about the anchor 110. The anchor 110 does not move since it is physically fixed to the substrate.

A first capacitor (Z1) is formed between the proof mass 104 and a first bottom electrode 112 that is attached to the substrate. Additionally a second capacitor (Z2) is formed between the proof mass 104 and a second bottom electrode 114 that is also attached to the substrate. As the proof mass 104 wobbles about the anchor 110 in response to various forces, capacitance values of the first capacitor (Z1) and the second capacitor (Z2) also vary. A controller (not shown) calculates values for these various forces (e.g. pressure, acceleration, etc.) based on the capacitance variations Z1, Z2.

Given that semiconductor fabrication is imperfect, the first spring 106 and/or the second spring 108 may have an undesired tapering in the z-axis that narrows the further out along the z-axis away from the substrate (i.e. a trapezoidal cross-section as shown in Figure 1B). The taper may not be in the x-y-plane.

Cross-axis sensitivity is caused by this tapering of the springs 106, 108. Cross-axis sensitivity is a torsional, twisting where forces in the x-y-plane cause undesired movement along the z-axis. Cross-axis sensitivity in many microelectromechanical system (MEMS) devices is a critical performance parameter.

For example, vertical (z-axis) MEMS accelerometers are required to be highly insensitive to cross-axis acceleration (accelerations originating in the x-axis and/or y-axis). Even a very small amount of tapering can cause an out-of-spec cross-axis sensitivity problem (e.g. a 0.35 degree taper is enough to cause out of spec performance).

Detecting such very small tapering in the springs 106, 108 or many other semiconductor structures is very difficult if not impossible during back-end wafer testing often using test probes placed in temporary contact with pads on the MEMS device 100.

Note, semiconductor structure tapering is different than skew. Skew has a parallelogram cross-section while tapering has a trapezoidal cross-section. Skew may be an important constraint for some semiconductor devices, but may not be an important constraint for other types of semiconductor devices (e.g. skew can present significant problems for MEMS gyro quadrature, but does not cause any issue with Z-accel cross-axis sensitivity.)

Now discussed is a calibration device (e.g. a metrology (i.e. test) structure, a circuit, etc.) for accurately quantifying cross axis-sensitivity due to tapering in semiconductor structures. Such structures in some example embodiments may be part of an electrical circuit or an electrical device. However, in other example embodiments, such structures may be part of an optical device, a meta-material device, an antenna device, or other structures.

In some example embodiments, the calibration device is only used during back-end semiconductor wafer quality sorting (i.e. acceptance criteria for detecting good and bad wafer structures). However, in other example embodiments the calibration device can be used for real-time testing and/or calibration of various semiconductor structures in a chip package and perhaps in operation for functional safety testing over a lifetime of the structure.

Thus in some example embodiments, a set of MEMS devices fabricated on a wafer may each have their own calibration device to measure cross axis-sensitivity. While in other example embodiments, a single calibration device can be part of a separate test structure embedded in the wafer and using back-end test probes is used to characterize (e.g. pass/fail) all of the structures/circuits on the wafer, but which is then later discarded (e.g. diced off).

The calibration device can thus enable closed loop monitoring of critical performance parameters after wafer fabrication. The calibration device can improve process control and reduce a risk of a large amount of fabrication resources being affected by a process excursion before detecting the issue at final test.

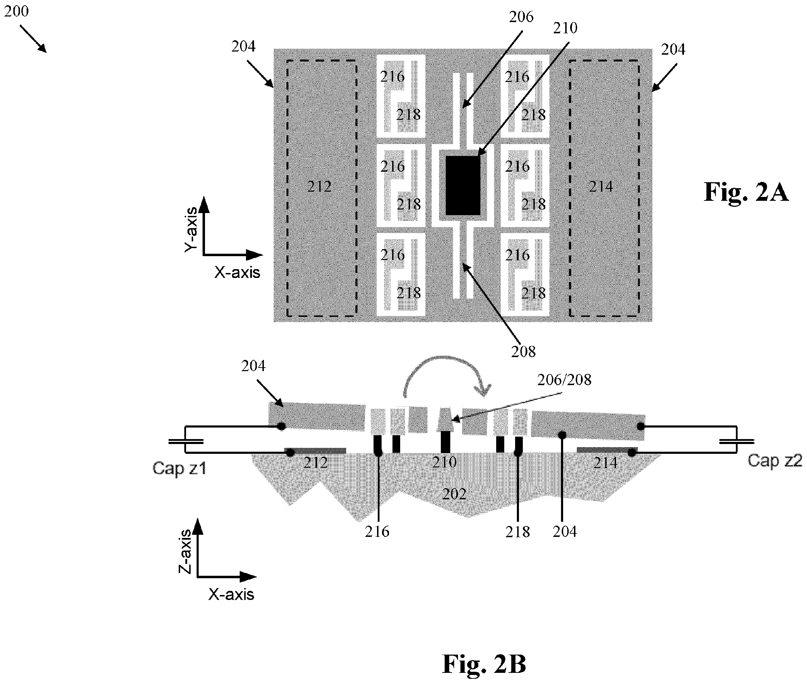

Figures 2A, 2B represent an example 200 of a calibration device. The example calibration device 200 is fabricated in an x-y-plane over a semiconductor substrate 202, and in some examples may be embedded in a semiconductor wafer having other circuits, structures, devices, etc. (not shown). The example calibration device 200 includes a proof mass 204, a first spring 206 (e.g. a first torsional element), a second spring 208 (e.g. a second torsional element), and an anchor 210.

The anchor 210 (e.g. pivot point) is physically coupled to one end of both the first spring 206 and the second spring 208. The anchor 210 is also physically coupled to the substrate 202. Another end of both the first spring 206 and the second spring 208 is physically coupled to the proof mass 204. The proof mass 204 is sensitive to various forces (e.g. pressure, acceleration, etc.) that cause the proof mass 204 to move (e.g. rotate, twist, etc.) about the anchor 210. The anchor 210 does not move since it is physically fixed to the substrate 202.

A first capacitor (Z1) is formed between the proof mass 204 and a first bottom electrode 212 that is attached to the substrate. Additionally a second capacitor (Z2) is formed between the proof mass 204 and a second bottom electrode 214 that is also attached to the substrate. As the proof mass 204 moves (e.g. rotates, twists, etc.) about the anchor 210 in response to various forces, capacitance values of the first capacitor (Z1) and the second capacitor (Z2) also vary.

A controller (not shown) calculates values for these various forces (e.g. pressure, acceleration, etc.) based on the capacitance variations Z1, Z2. In some example embodiments, the controller is included in a test probe (not shown) that is brought into contact with a set of test pads on the calibration device 200 during testing. In other example embodiments, the controller is embedded along with the calibration device 200 in a circuit to be tested.

The calibration device 200 also includes a first set of bias electrodes 216 and a second set of bias electrodes 218. In many example embodiments, all of the first set of bias electrodes 216 are electrically coupled together and all of the second set of bias electrodes 218 are electrically coupled together. These sets of bias electrodes 216, 218 are used to calculate cross-axis sensitivity for one or more devices that have springs 206, 208 or similar structures, as will be further discussed below.

The bias electrodes 216, 218 are attached to the substrate 202 and do not move; however, the proof mass 204 moves about the anchor 210 in response to either forces during normal operation of the calibration device 200, or in response to voltages applied to the bias electrodes 216, 218 which create electrostatic forces during testing and calibration. Also, while Figure 2A shows the bias electrodes 216, 218 as flag-like structures, in alternate example embodiments the bias electrodes 216, 218 can be of any shape (e.g. a rectangle, square, circle, etc.).

In some example embodiments, the first set of bias electrodes 216 are also coupled to a first test pad, and the second set of bias electrodes 218 are also coupled to a second test pad so that they can be accessed by a test probe, perhaps during back-end wafer testing and sorting based on cross-axis sensitivity. The test probe would also be in contact with additional test pads (e.g. to the substrate 202 and the bottom electrodes 212, 214) to measure the Z1 and Z2 capacitances. In these example embodiments, the cross-axis sensitivity can be used as a wafer pass/fail criteria for all devices on the wafer that have springs 206, 208 or similar fabricated structures.

In other example embodiments, the first set of bias electrodes 216 are also coupled to the controller, and the second set of bias electrodes 218 are also coupled to the controller so that the controller can calculate cross-axis sensitivity for the first spring 206 and the second spring 208 using the calibration device 200. The controller would also be coupled to additional test pads (e.g. to the substrate 202 and the bottom electrodes 212, 214) to measure the Z1 and Z2 capacitances. In these example embodiments, the cross-axis sensitivity measurements can be stored in a memory to be used later during device operation for functional safety or ongoing calibration purposes.

In some example embodiments, a cross-axis sensitivity of the calibration device 200 is tested and calculated as follows. First, when the calibration device 200 is otherwise in a quiescent state (i.e. not subject to physical/movement forces), the controller applies an electrical voltage (Vbias) across the first bias electrode 216 and the anchor 210. This Vbias voltage creates electrostatic forces between the proof mass 204 and the first bias electrode 216 that simulate a lateral physical acceleration on the proof mass 204 (i.e. the springs 206, 208 move, rotate, twist, etc.). Second, the controller measures the Z1 and Z2 capacitances between the proof mass 204 and the bottom electrodes 212, 214. Third, the controller applies the same electrical voltage (Vbias) across the second bias electrode 218 and the anchor 210. Fourth, the controller again measures the Z1 and Z2 capacitances between the proof mass 204 and the bottom electrodes 212, 214. Fifth, the controller grounds both the bias electrodes 216, 218 and the anchor 210. Sixth, the controller measures the Z1 and Z2 capacitances between the proof mass 204 and the bottom electrodes 212, 214.

The Z1 and Z2 capacitors change their capacitance based on an amount of tilt/lateral acceleration caused by these three different voltage applications on the bias electrodes 216, 218.

In some example embodiments, the controller grounds the first set of bias electrodes 216 when Vbias is applied to the second set of bias electrodes 218, and vice versa, to reduce noise during the capacitance Z1, Z2 measurements. Note electrical insulation (e.g. oxide layers) are added between the substrate 202, the anchor 210, the first bottom electrode 212, the second bottom electrode 214, the first set of bias electrodes 216, and the second set of bias electrodes 218 as needed to prevent short circuits as various voltages are applied and capacitance Z1, Z2 measurements are taken.

An exaggerated z-axis tilt in response to the applied Vbias voltages is shown in Figure 2B. As mentioned earlier, this tilting is undesired and results from cross-axis sensitivity. If there was no cross-axis sensitivity, then the proof mass 204 would just move in the x-y-plane of the substrate 202 and there would be no tilt. Thus cross-axis sensitivity caused by tapering in the springs 206, 208 tilts the proof mass 204 in the z-axis perpendicular to the x-y-plane of the substrate 202.

With these three sets of Z1 and Z2 capacitance measurements under these three different voltage applications to the bias electrodes 216, 218, the controller can calculate the cross-axis sensitivity of the calibration device 200.

An example equation for calculating cross-axis sensitivity based on these capacitance Z1, Z2 measurements is: Sx=C*(ΔZ1-ΔZ2), where Sx is the cross-axis sensitivity, C is a proportionality constant dependent upon design of structure and voltage level applied during test, and ΔZ1 and ΔZ1 is the change in Z1 and Z2 capacitance observed when applying test bias.

Note, while Figure 2A shows bias electrodes 216, 218 on both sides of the springs 206, 208, in other example embodiments, the first set of bias electrodes 216 can just be on one side of the springs 206, 208, and the second set of bias electrodes 218 can just be on the other side of the springs 206, 208.

Also in other example embodiments additional rows of bias electrodes can be added to either or both sides of the torsion springs to further increase a sensitivity of the Z1 and Z2 capacitances measured and thus a more accurate cross-axis sensitivity calculation.

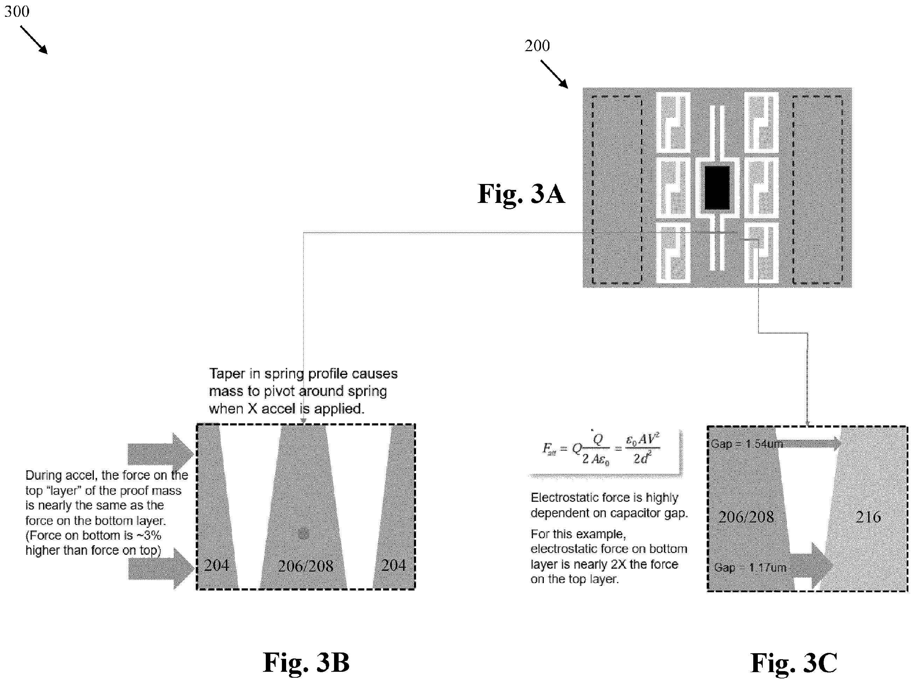

Figures 3A, 3B, 3C represent a potential non-ideality 300 in the calibration device 200. For example, in some applications applying the Vbias voltages may introduce an additional non-ideality.

During normal operation of the springs 206, 208, as shown in Figure 3B, the physical forces on the springs 206, 208 from the proof mass 204 movement is substantially equal from top to bottom of the springs 206, 208.

However, as shown in Figure 3C, the electrostatic forces caused by the Vbias voltage may be much larger on the bottom of the proof mass than the top, since the same non-ideal etch process that causes tapering of the springs 206, 208 also affects the bias electrodes 216, 218. This results in a "reverse tapering" of the gap between the springs 206, 208 and the bias electrodes 216, 218 over which the electrostatic forces are applied. This effect causes a moment opposite to the moment caused by the tapering in the springs 206, 208.

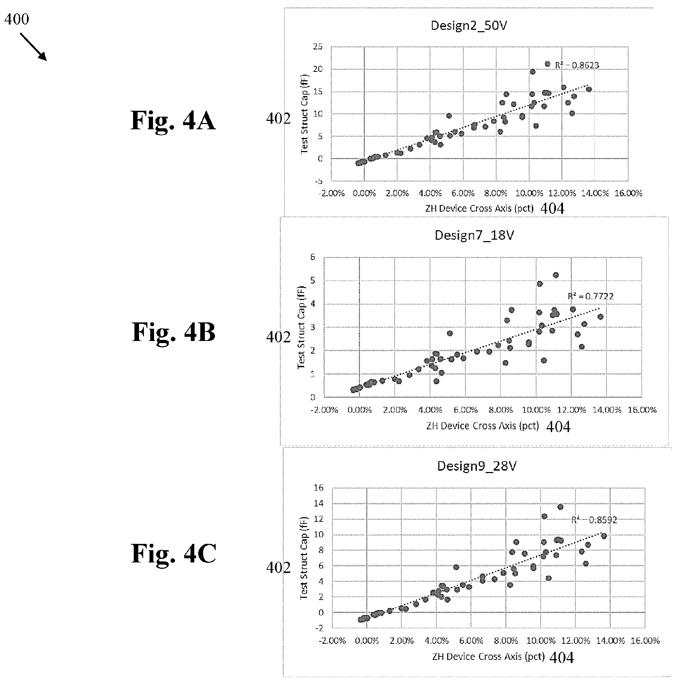

Figures 4A, 4B, 4C represent example simulation results 400 for various example embodiments of the calibration device. The simulation results 400 compare the Z1, Z2 capacitance 402 measurement to cross-axis sensitivity 404 even in a presence of the potential non-ideality 300. The simulation results illustrate a good correlation between the Z1, Z2 capacitance measurements 402 by the controller in response to the Vbias voltages on the bias electrodes 216, 218 and the actual cross-axis sensitivity 404.

Various instructions and/or operational steps discussed in the above Figures can be executed in any order, unless a specific order is explicitly stated. Also, those skilled in the art will recognize that while some example sets of instructions/steps have been discussed, the material in this specification can be combined in a variety of ways to yield other examples as well, and are to be understood within a context provided by this detailed description.

In some example embodiments these instructions/steps are implemented as functional and software instructions. In other embodiments, the instructions can be implemented either using logic gates, application specific chips, firmware, as well as other hardware forms.

When the instructions are embodied as a set of executable instructions in a non-transitory computer-readable or computer-usable media which are effected on a computer or machine programmed with and controlled by said executable instructions. Said instructions are loaded for execution on a processor (such as one or more CPUs). Said processor includes microprocessors, microcontrollers, processor modules or subsystems (including one or more microprocessors or microcontrollers), or other control or computing devices. A processor can refer to a single component or to plural components. Said computer-readable or computer-usable storage medium or media is (are) considered to be part of an article (or article of manufacture). An article or article of manufacture can refer to any manufactured single component or multiple components. The non-transitory machine or computer-usable media or mediums as defined herein excludes signals, but such media or mediums may be capable of receiving and processing information from signals and/or other transitory mediums.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A calibration device, comprising:
a substrate;
a torsional element;
wherein a first end of the torsional element is coupled to the substrate;
wherein a second end of the torsional element is moveable and defines a capacitance with the substrate;
a bias electrode coupled to the substrate;
wherein the torsional element and the bias electrode are positioned such that a bias voltage applied between the substrate and the bias electrode creates an electrostatic force between the bias electrode and the torsional element;
wherein the electrostatic force causes movement between the torsional element and the substrate; and
wherein the movement varies the capacitance.

2. The device of claim 1:
wherein the torsional element is a spring.

3. The device of any of the preceding claims:
wherein the second end of the torsional element is coupled to a moveable proof mass.

4. The device of any of the preceding claims:
wherein the bias electrode is a first bias electrode positioned apart from and to a first side of the torsional element;
further comprising a second bias electrode coupled to the substrate and positioned apart from and to a second side of the torsional element;
wherein the first side and the second side are on opposite sides of the torsional element.

5. The device of claim 4:
wherein the bias voltage applied between the substrate and the first bias electrode creates a first electrostatic force that moves the torsional element in a first direction and sets the capacitance to a first capacitance; and
wherein the bias voltage applied between the substrate and the second bias electrode creates a second electrostatic force that moves the torsional element in a second direction and sets the capacitance to a second capacitance.

6. The device of any of the preceding claims:
wherein the substrate and the torsional element are formed in parallel x-y-planes; and
wherein the bias voltage causes the torsional element movement in a z-axis that is perpendicular to the x-y-planes.

7. The device of claim 6:
wherein the torsional element has a trapezoidal cross-section along the z-axis.

8. The device of any of the preceding claims:
wherein the electrostatic force simulates a lateral acceleration of the torsional element.

9. The device of any of the preceding claims:
further comprising a first bottom electrode and a second bottom electrode, both coupled to the substrate;
wherein the electrostatic force moves the torsional element away from the first bottom electrode and closer to the second bottom electrode.

10. The device of any of the preceding claims:
wherein the capacitance variation defines a cross-axis sensitivity of the torsional element.

11. The device of claim 10:
further comprising a controller;
wherein the controller is configured to calculate the cross-axis sensitivity based on the capacitance variation in response to the bias voltage.

12. The device of claim 10 or 11:
wherein the bias electrode is included in a first set of bias electrodes all coupled to the substrate and positioned along both the first side and the second side of the torsional element;
further comprising a second set of bias electrodes all coupled to the substrate and positioned along both the first side and the second side of the torsional element.

13. The device of claim 12:
wherein the controller is configured to apply the bias voltage to the first set of bias electrodes and apply a ground voltage to the second set of bias electrodes at a same time.

14. The device of claim 12 or 13:
wherein increasing a number of bias electrodes in either or both the first and second sets of bias electrodes increases the capacitance variation in response to the bias voltage.

15. A method of calculating cross-axis sensitivity using a calibration device:
wherein the calibration device includes, a substrate; a torsional element; wherein a first end of the torsional element is coupled to the substrate; wherein a second end of the torsional element is moveable and defines a capacitance with the substrate; a bias electrode coupled to the substrate; wherein the torsional element and the bias electrode are positioned such that a bias voltage applied between the substrate and the bias electrode creates an electrostatic force between the bias electrode and the torsional element; wherein the electrostatic force causes movement between the torsional element and the substrate; and wherein the movement varies the capacitance; and
wherein the method of calculating cross-axis sensitivity includes,
applying the bias voltage across the bias electrode and the torsional element;
measuring the capacitance variation between the torsional element and the substrate; and
calculating the cross-axis sensitivity based on the capacitance variation in response to the applied bias voltage.
